# EUROPEAN PATENT APPLICATION

(11) **EP 1 734 149 A2**
(43) Date of publication of application: **20.12.2006**
(21) Application number: 06011555.7
(22) Date of filing: 03.06.2006
(51) Int. Cl.: C23C 14/34, C23C 14/54

(54) **Method for controlling ion density in a sputtering system**

(30) Priority: 14.06.2005 US 152469
(71) Applicant: Applied Films Corporation, Longmont, CO 80504 (US)
(72) Inventor: Stowell, Michael W., Loveland, CO 80538 (US)
(74) Representative: Schickedanz, Willi

(57) **Abstract**

A method for controlling ion density and sputtering rate in a sputtering system is disclosed. In one embodiment, a first pulse-width power signal is applied to the cathode to thereby generate a higher concentration of ions. The pulse-width of the first pulse-width power signal is then decreased to thereby increase the sputtering rate and decrease the ion density around the cathode. Next, the process is repeated to create a modulated signal.

## Description

### FIELD OF THE INVENTION

The present invention relates to power supplies and systems for sputtering.

### BACKGROUND OF THE INVENTION

Coated substrates are found almost everywhere and are critical for today's consumer products, solar products, and glass. For example, typical consumer products that utilize coated substrates include cell phone displays, flat-panel computer displays, flat-panel televisions, personal digital assistants, and digital watches. These coated substrates are generally formed by depositing a thin layer of material on a particular substrate. Often, this deposited material is a transparent conductive oxide (TCO), which transmits light and can conduct electrical current. Exemplary TCOs include indium tin oxide (ITO) and aluminum zinc oxide (AZO), but other TCOs are known to those of skill in the art.

Manufacturers use a process known as "sputtering" to deposit TCOs and other films on substrates. Sputtering involves atomizing a target by bombarding it with ions. The atoms sputtered from the target are deposited on a substrate, which is generally moved past the target during the sputtering process. The sputtered atoms collect on the substrate and form crystals and eventually a film. High density and high-quality crystals are important to high-quality films.

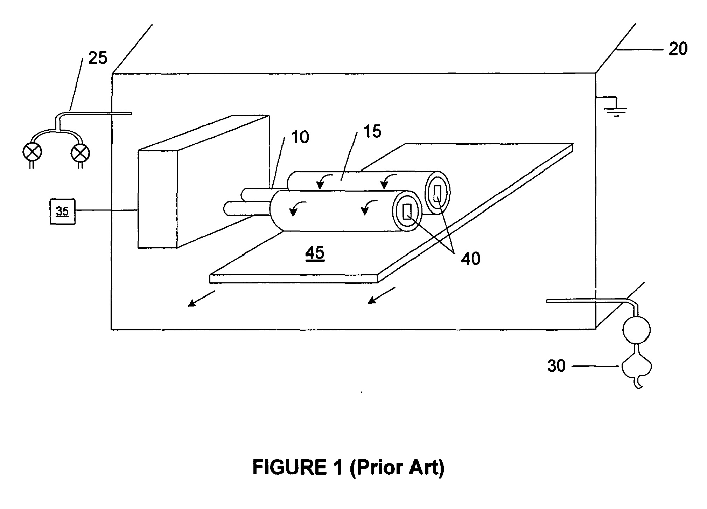

Figures 1 through 4 illustrate implementations of the sputtering process. Figure 1, for example, illustrates a sputtering system known as a "rotatable magnetron." This system is often used for a coating glass. The basic rotatable magnetron includes a rotatable cathode 10 and a target 15, both of which are located inside a vacuum chamber 20. The vacuum chamber 20 includes a gas inlet 25 and gas exit port 30 for introducing gas into and removing gas from the vacuum chamber 20. The basic system also includes a power supply 35, which could be, among other things, an AC, DC, or RF-based power supply. The power supply 35 provides energy to the cathodes 10 to ignite the gas inside the chamber 20 so that a plasma is formed around the cathode 10. The gas ions produced by the plasma are focused by a magnet assembly 40 located inside the rotatable cathode 10 so that the ions bombard the target 15 and sputter atoms of the target 15. Finally, this rotatable magnetron system includes a substrate transport system 45 that moves a substrate by the cathode 10 during the sputtering process. The atoms sputtered from the target 15 settle on the substrate and form a film.

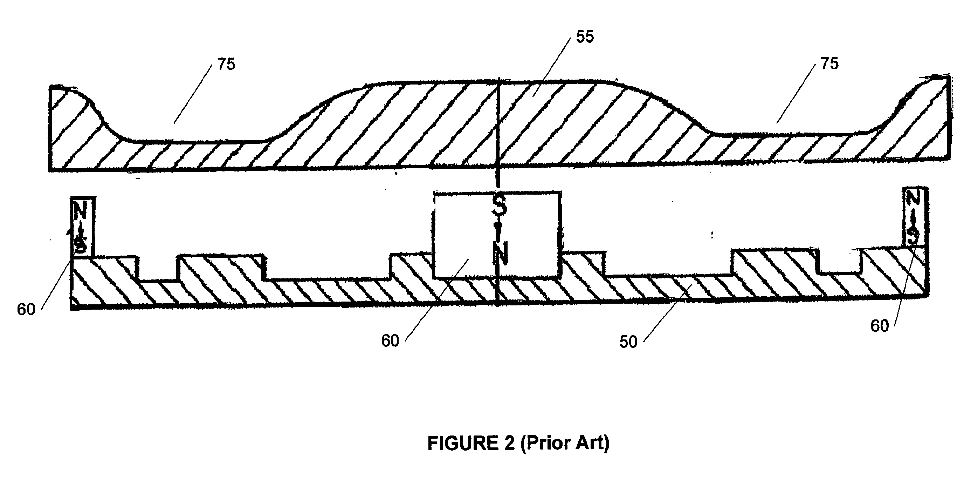

Figure 2 illustrates a cross section of a portion of another sputtering system. This system is referred to as a "planar magnetron" because it uses a planar cathode 50 and planar target 55 rather than a rotatable cathode and target. Like the rotatable magnetron, the planar magnetron uses magnets 60 to force ions from the plasma to bombard the target 55. The planar magnetron is commonly used for producing thin films for displays.

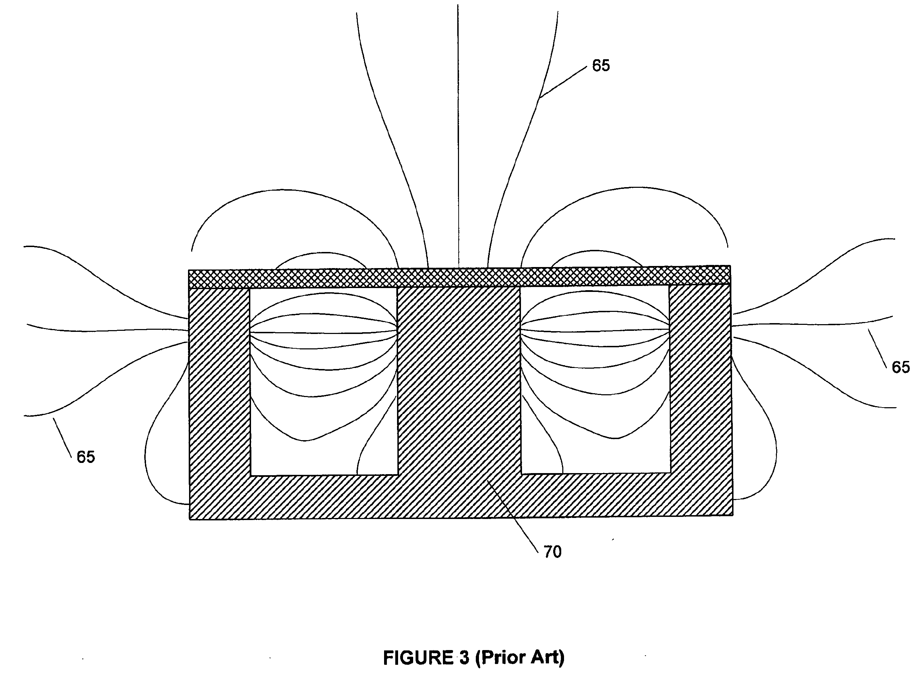

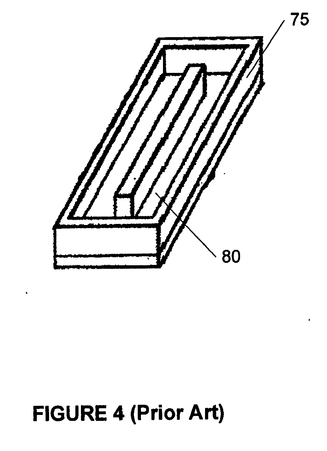

Figure 3 illustrates the magnetic fields 65 created by the magnet assembly 70 included in a planar magnetron. The magnetic fields confine the electrons and secondary electrons on and near the surface of the sputtering cathode generating ions as they move through drift around the race track. The Ions created bombard the target (shown in Figure 2 as element 55). As can be seen in Figure 2, this bombardment is considerably more intense on certain portions of the target 55. For example, two portions 75 of the target 55 have been significantly sputtered while the remaining portions of the target 55 are relatively untouched. The pattern formed by this sputtering process is known as a "race track." Figure 4 illustrates a planar target 75 with a well-formed race track 80. The target 75 was originally a rectangular block, and the sputtering process atomized the material in the race-track area 80 and deposited it on a substrate.

Due to the increase in products requiring thin films, the thin-film industry has recently placed increased emphasis on thin-film quality. Poor-quality films often result from unwanted debris collecting on the substrate and/or from films poorly forming on the substrate. The thin-film industry has addressed these film-quality issues in a variety of ways, including modifying power supplies and introducing ion-assisted deposition processes. But the industry has not yet developed reliable, efficient, and commercially practical solutions to its debris and film formation problems for these new thin film requirements.

The debris problem facing the film industry (both thick and thin) involves two debris types. The first debris type includes debris that comes from the target, and the second debris type comes from the growing film itself and the substrate carrier. This second type of debris is often created after debris from the target impacts the film. Debris that comes from the target is often the result of nodules and electrical arcing. (Nodules are build ups of material on a target, and are often formed when sputtered material is deposited on the target or cathode rather than on the substrate.)

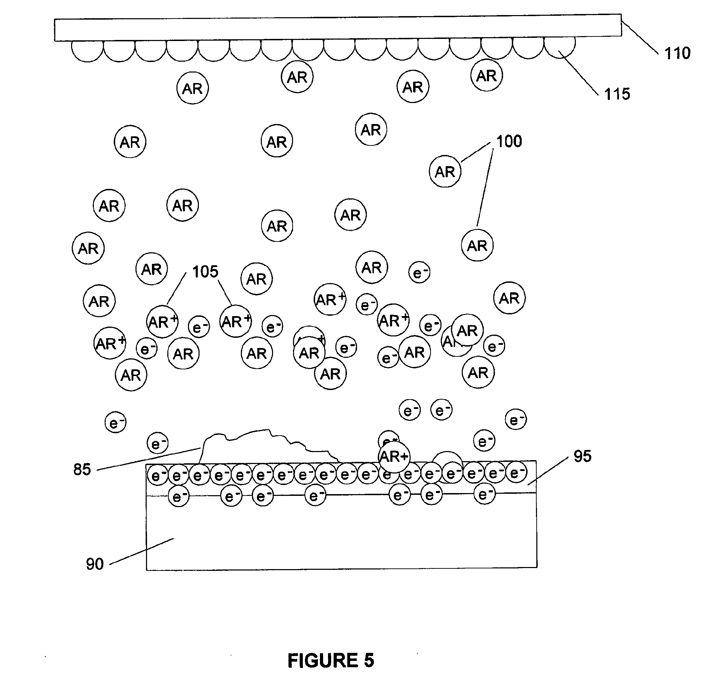

Figure 5 illustrates an example of a typical nodule 85 that forms on a cathode 90 and/or a target 95. In this example, the cathode 90 and target 95 are shown as separate components that are adjacent. For example, the target 95 could be formed of ITO, and it could be bonded or otherwise coupled to the cathode 90. Generally, the system should sputter the ITO target 95 but not the cathode 90 supporting the target 95. In other embodiments, the cathode 90 and target 95 could be integrated as a single unit or be the rotatable type.

The plasma in this sputtering system is formed from Argon gas 100. The power supply (not shown) provides power to the cathode 90 to ionize the gas ― thereby forming positively-charged ions 105 that are attracted to the negatively charged cathode 90 and target 95. The power applied to the cathode 90 is steady-state DC in this implementation ― although those of skill in the art could use other types of power.

Once ions 105 are formed, the electrical attraction between the ions 105 and the negatively charged target 95 results in the target's bombardment and sputtering of the target material. The sputtered material is for the most part deposited on the substrate 110 as a film 115. But some sputtered material redeposits on the cathode 90 and/or target 95 and forms nodules 85.

Nodules can cause significant problems ― the most serious of which is arcing and debris. Positively charged ions that are attracted toward the negatively-charged target collect on a nodule and cause it to physically grow or be grown over. And as the ions build on the nodule, a potential develops between the nodule and the target surface and current flows along its surface. At some point, either through thermal stress or dielectric breakdown, an arc forms between the nodule and the target surface. This arc essentially causes the nodule to explode and blow particles toward the substrate creating debris. These particles can impact the growing film much as a meteor impacts the moon.

Target particles that impact the film can cause three problems. First, they can disrupt the crystals growing on the film. In some instances, the impact can cause large scars and craters on the film surface. Second, the debris from the target can break loose existing film particles ― leaving film shadows during the deposition process. These particles are then redeposited on other portions of the film. Finally, high temperature debris blown from the target can burn the growing film, especially if it has been grown on a polymer

Even if film growth is not disrupted by debris, films may still not form properly. A significant problem plaguing film manufactures relates to micro-crystalline quality, nonuniform film growth, and stoichiometry. Some of these properties can be measured and the bulk resistance calculated, which is a measure of bulk-material conductivity. One method for solving this film-equality problem includes ion-assisted deposition. Ion-assisted deposition systems generally add a separate ion source to a sputtering system. The ions from this extra ion source help to settle or pack a film as it is growing. The ion source is distinct from the cathode and target, and it is very expensive. This expense has prevented ion-assisted deposition from being widely adopted.

Accordingly, a system and method are needed to assist with film growth and to address the problems with present technology, including, but not limited to, the problems listed above.

### SUMMARY OF THE INVENTION

Exemplary embodiments of the present invention that are shown in the drawings are summarized below. These and other embodiments are more fully described in the Detailed Description section. It is to be understood, however, that there is no intention to limit the invention to the forms described in this Summary of the Invention or in the Detailed Description. One skilled in the art can recognize that there are numerous modifications, equivalents and alternative constructions that fall within the spirit and scope of the invention as expressed in the claims.

One implementation involves a method for controlling ion density and sputtering rate in a sputtering system. In one embodiment, a first pulse-width power signal is applied to the cathode to thereby generate a higher concentration of ions. The pulse-width of the first pulse-width power signal is then decreased to thereby increase the sputtering rate and decrease the ion density around the cathode. Next, the process is repeated to create a modulated signal.

Other implementations, some of which are described below, use other modulated power signals.

### BRIEF DESCRIPTION OF THE DRAWINGS

Various objects and advantages and a more complete understanding of the present invention are apparent and more readily appreciated by reference to the following Detailed Description and to the appended claims when taken in conjunction with the accompanying Drawing wherein:
FIGURE 1 illustrates an exemplary rotatable magnetron for sputtering;
FIGURE 2 illustrates a cross section of an exemplary planar magnetron and target;
FIGURE 3 illustrates a cross section of an exemplary planar magnetron and the corresponding magnetic field lines;
FIGURE 4 illustrates an exemplary race track formed in a planar target;
FIGURE 5 is a block diagram illustrating a nodule formed on a target;
FIGURE 6A illustrates the arc prevention abilities of a pulsed DC power supply;
FIGURE 6B illustrates the pulsed DC waveform corresponding to Figure 6A;
FIGURE 7 illustrates the film properties that result from sputtering with steady-state DC voltage;
FIGURE 8A illustrates three phases of the process for sputtering with a power signal that includes RF superimposed on pulsed DC;
FIGURE 8B illustrates the pulsed-DC waveform corresponding to Figure 8A;
FIGURES 9A and 9B illustrate the film resulting from superimposed RF with and without pulsed DC;
FIGURE 10 illustrates an exemplary chart linking bulk resistance to ion energy;
FIGURES 11A and 11B illustrate pulsed-DC measurements at a target and measurements of the resulting ion energy;
FIGURE 12 illustrates a power supply and sputtering system constructed in accordance with the principles of the present invention;
FIGURE 13 illustrates a power supply and sputtering system constructed in accordance with the principles of the present invention;
FIGURE 14 illustrates a power supply constructed in accordance with the principles of the present invention;
FIGURE 15 illustrates a power supply and sputtering system constructed in accordance with the principles of the present invention;
FIGURE 16A illustrates a frequency-modulated power signal usable with one implementation of the present invention;
FIGURE 16B illustrates the impact on ion density and ion energy of a frequency modulated power signal;
FIGURE 17A illustrates an amplitude-modulated power signal usable with one implementation of the present invention;
FIGURE 17B illustrates the impact on ion density and energy of an amplitude modulated signal
FIGURE 18A illustrates a pulse-width modulated signal usable with one implementation of the present invention;
FIGURE 18B illustrates the impact on ion production and energy of a modulated pulse-width signal;
FIGURE 19 illustrates a pulse-position modulated signal usable with one implementation of the present invention;
FIGURE 20 illustrates pulse-amplitude modulation using pulsed DC in accordance with one implementation of the present invention;
FIGURE 21 illustrates pulse-width modulation using pulsed DC in accordance with one implementation of the present invention; and
FIGURE 22 illustrates pulse-position modulation usable with one implementation of the present invention.

### DETAILED DESCRIPTION

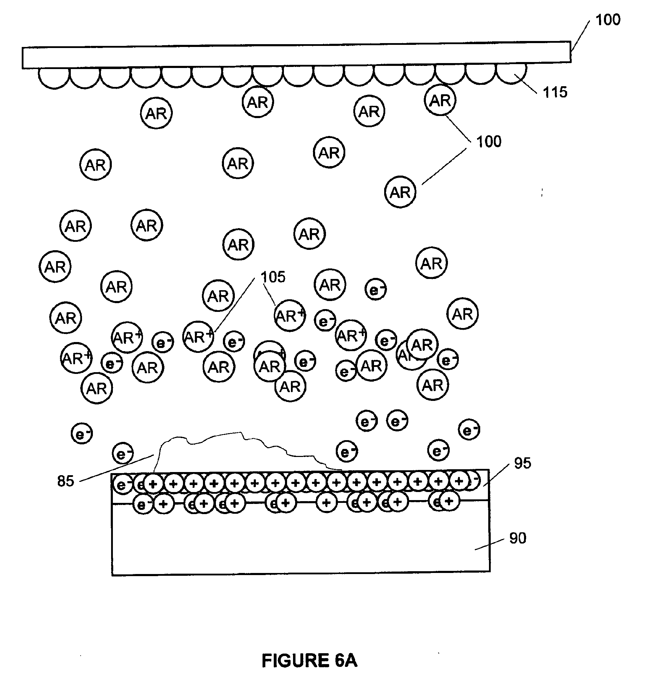

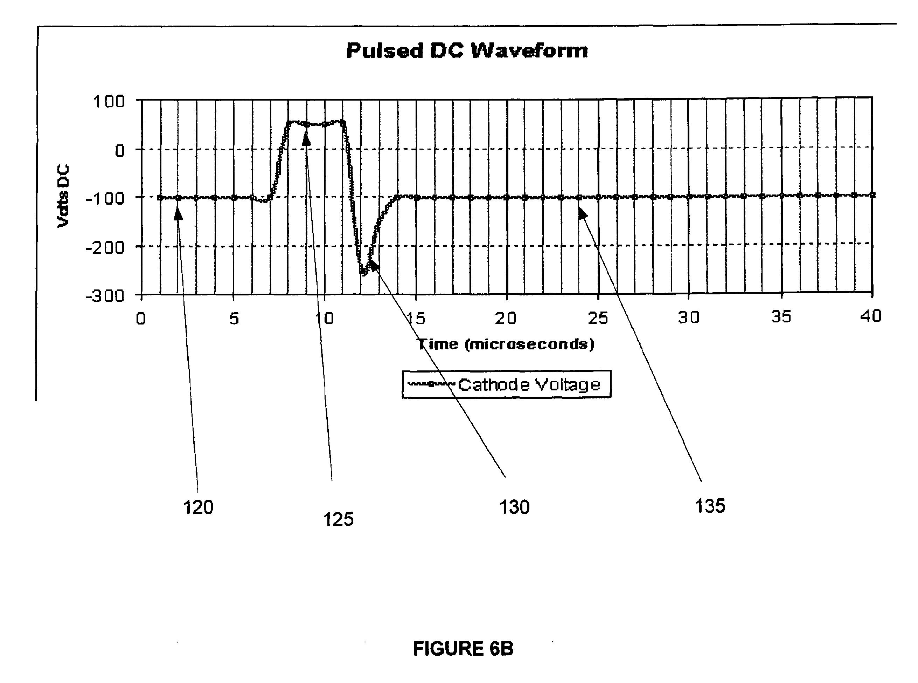

Referring now to the drawings, where like or similar elements are designated with identical reference numerals throughout the several views, and referring in particular to FIGURES 6A and 6B, they illustrate the arc prevention capabilities of a sputtering system that includes a pulsed-DC power supply. In this illustration, a pulsed-DC power supply (not shown) is used to provide a pulsed-DC signal to the cathode 90.

Figure 6B illustrates a pulsed-DC signal corresponding to Figure 6A. Notice that the stable voltage 120 is around negative 100 volts (-100). At periodic intervals, the power supply reverses the voltage for a short period. For example, the power supply can provide a 3 or 4 microsecond positive pulse 125 to the cathode 90. This positive pulse 125 positively charges the target 95 and the cathode 90. Figure 6A reflects this charge with the "+" signs on the target 95. Because the Argon ions 105 are also positively charged, they are repelled by the same positive charge on the target 195, the other case that also occurs at the same time is that the electrons are drawn toward the cathode from the bulk plasma and recombine with the positive ions to neutralize them thus removing the charge build up. Thus, the reverse pulse 125 expels some fraction of the accumulated ions from the nodule 85, the ions in the bulk plasma out toward the substrate are more likely to be sent toward the substrate during the reversal (positive voltage) providing ion bombardment to the growing film. The nodule will remain, but the ions on the nodule and the arc potential between the module 85 and target surface are greatly reduced.

Still referring to Figure 6B, after the reverse pulse 125, the power supply is returned to a normal operating state. That is, the power supply provides forward pulse 130 and then a stable voltage 135 of approximately negative 100 (-100) volts. The frequency and duration of the reverse pulse, the reverse-pulse voltage, and the stable voltage can vary among different target materials and among different quality targets of the same material. Further, these parameters could even vary for the same target over time. Those of skill in the art know how to select the correct parameters for the particular target that they are using.

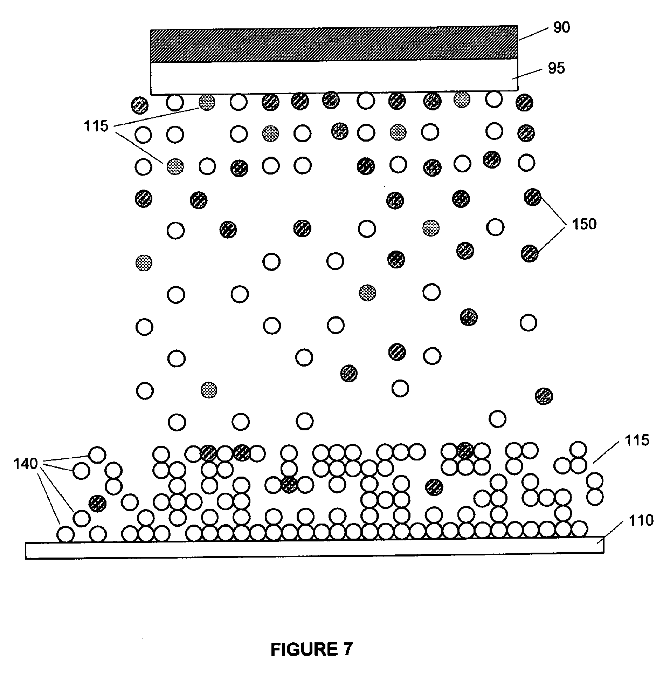

Figure 7 illustrates the film properties resulting from sputtering with steady-state DC voltage. In this system, a steady-state DC voltage (approximately 300 V) is applied to the cathode 90 and target 95. Ions 145 bombard the target 95, and sputtered material 140 collects on the substrate 110 as a film 115.

This film 115, however, is not uniform. It contains several gaps that negatively impact conductivity. These gaps indicate that the crystals are not forming properly and that the film will not be high quality.

Imperfect crystals and gaps can be caused by poor deposition and/or by high energy particles impacting the film. For example, an unnecessarily high cathode voltage can provide too much energy to the sputtered atoms 140, the reflected neutrals 150 or the generated ions 145. These high energy particles can impact a growing film 15 and cause disruption. Accordingly, voltage control at the cathode 90 can be useful in producing high quality films.

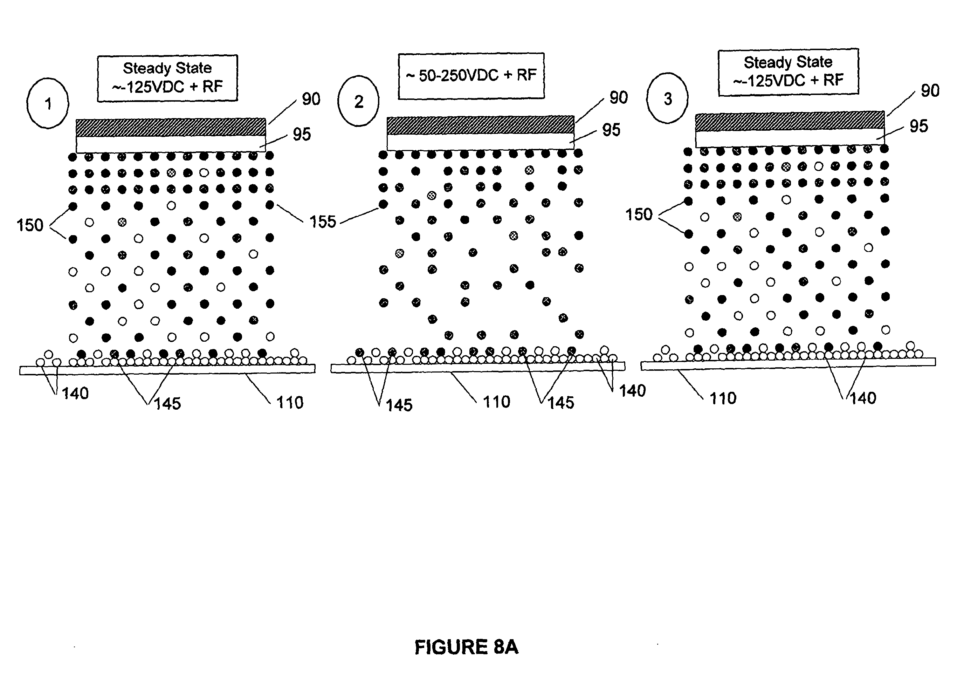

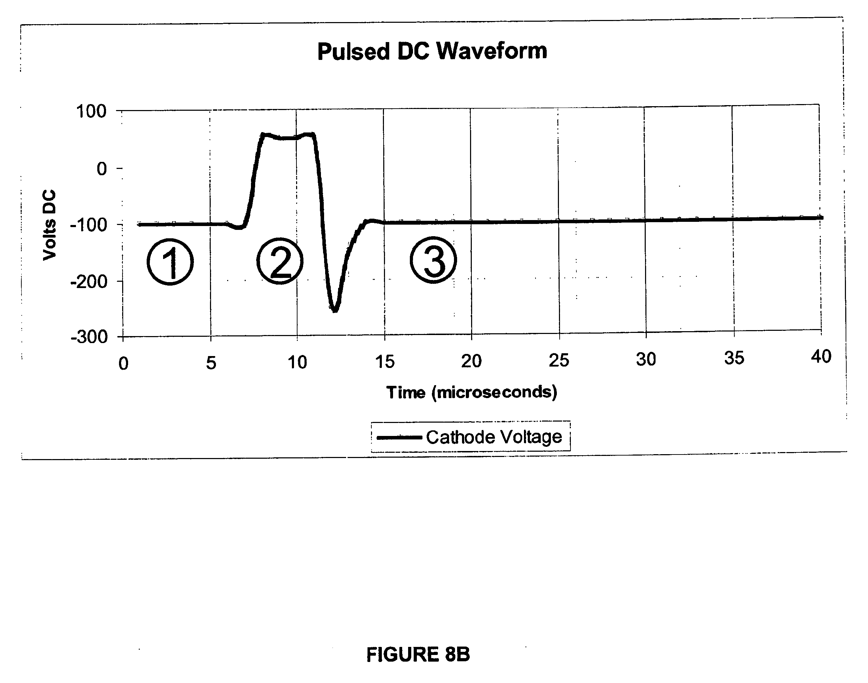

Referring now to Figures 8A and 8B, they illustrate three stages of the process for sputtering with super imposed RF and the pulsed-DC waveform (RF not illustrated) corresponding to each stage. In stage 1, a pulsed-DC voltage with a superimposed RF signal is applied to the cathode and target. The steady-state DC voltage is approximately 100 to 125 V. And the RF waveform is ~ +/- 800VAC to 2200VAC at 13.56MHZ but not limited to this frequency. By using the superimposed RF or any other modulated signal, the cathode voltage can be reduced, and ion / deposition energy can be better controlled. Similarly, the energy of the sputtered material 140 can be better controlled through lower cathode voltages.

During stage 1, the target 95 is being bombarded by ions 145 and the target 95 is being sputtered. Notice the high density of sputtered material 140 in stage 1. The sputtering rate is high, ion density is low, and electron 155 density is high.

The power supply (not shown) reverses the DC signal applied to the cathode 90 during stage 2. For example, the power supply pulses the voltage to between positive 50 and 250 volts. During stage 2, the sputtering rate is low. Notice the lack of sputtered species 140 when compared to stage 1.

But the production of ions 145 (including negatively charged desirable oxygen ion) in stage 2 is high when compared to stage 1. This increased number of ions will be available in stage 3 for bombarding the target. They are also available to gently impact the growing film 115 and pack or settle the sputtered material, thereby closing any film gasp. This process is represented by ions 145 on the film surface.

Finally, the power supply returns the voltage to a steady state in stage 3. This stage is similar to stage 1 and produces sputtered material 140 to continue film 115 growth.

These cycles of sputtering, deposition, ion creation, and compaction create better quality films. Essentially, these cycles sputter a layer for the film, pack that layer, and then sputter another layer. The superimposition of RF with pulsed DC is one way to generate these cycles. Other modulated signals can produce a similar result.

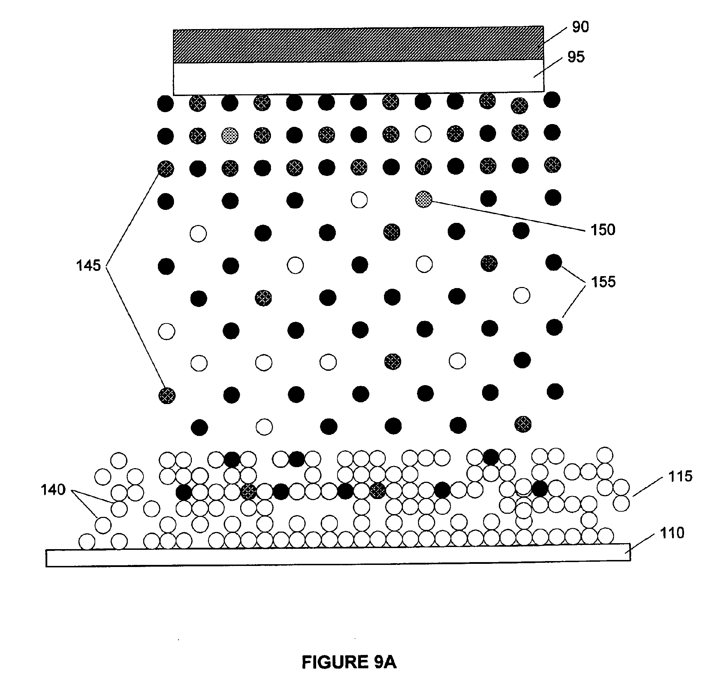

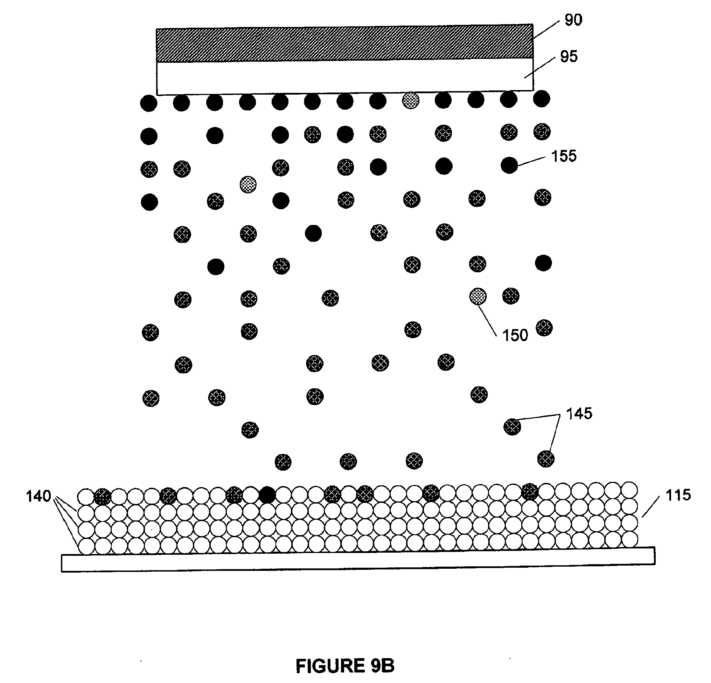

Figures 9A and 9B illustrate the benefits of utilizing superimposed RF with and without pulsed DC. Good sputtering results can are achieved by applying a combination of RF and pulsed DC to the cathode 90. An exemplary illustration of this type of film is shown in Figure 9B. In this system, the cathode 90 is powered by a pulsed-DC waveform and a superimposed RF signal or another modulated signal. The resulting film 115 is uniform and tightly packed.

Figure 9A illustrates a system that produces a slightly less desirable film 115 than does the system of 9B. But the system shown in Figure 9A can still produce good films. For this system, the cathode 90 is powered by a steady state DC voltage and a superimposed RF signal. The resulting film may have several gaps between the sputtered atoms.

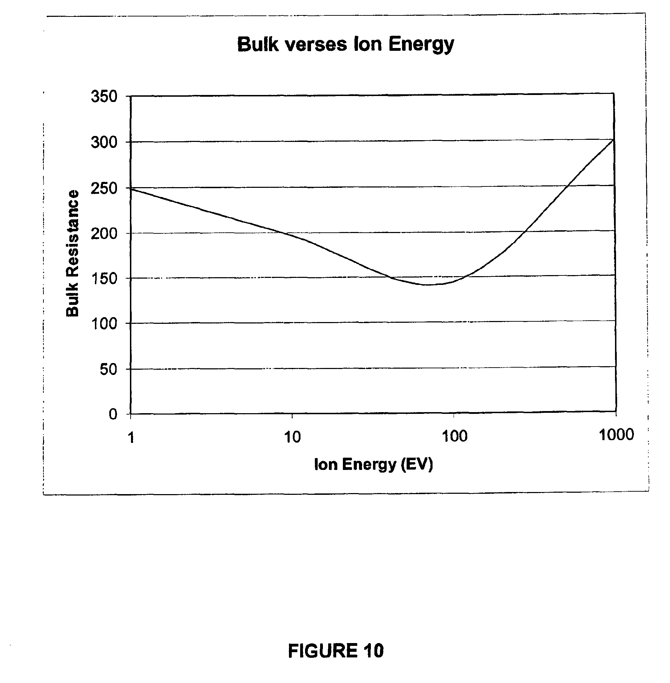

Figure 10 is an exemplary chart demonstrating the link between ion energy (EV) and film quality (bulk resistance). The particular values of this chart may vary according to the target material, but the general curve is illustrative. When ion energy is low (~1EV), the film quality could be lower (higher bulk resistance indicates a poorer quality film). And when ion energy is very high (~1000EV), the film quality is lower. But when ion energy is moderate, for example, in the 30 to 150 EV range and ion density controlled through the frequency, the film quality is higher. This chart demonstrates that film quality can be controlled by controlling ion energy during the sputtering process. Ions with too little energy do not cause collision cascading in film atoms. That is, ions with too little energy cannot help pack the film atoms together and eliminate gaps, (by the reduction of atomic shadowing). Ions with too much energy destroy forming film crystals and can actually increase the number of gaps and grain boundaries. One way to control ion energy is with power systems that include superimposed RF as described herein or other modulated power supplies.

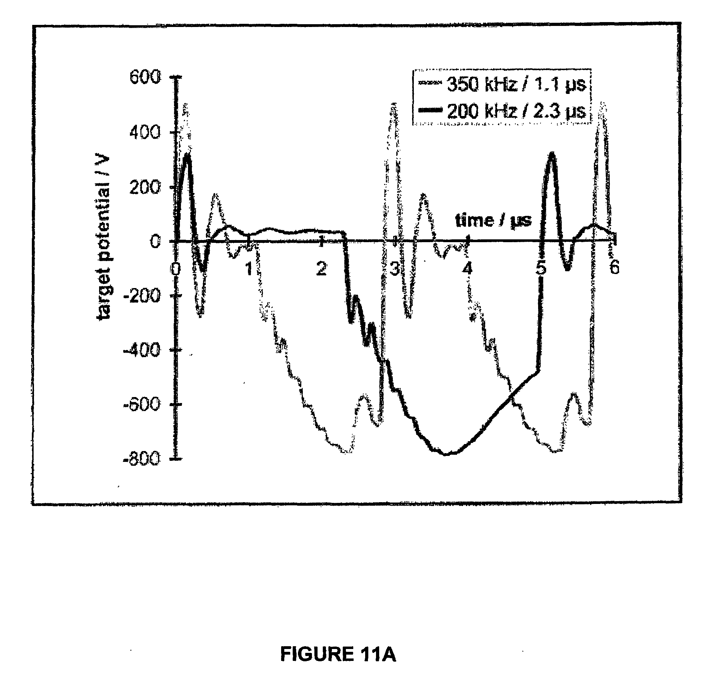

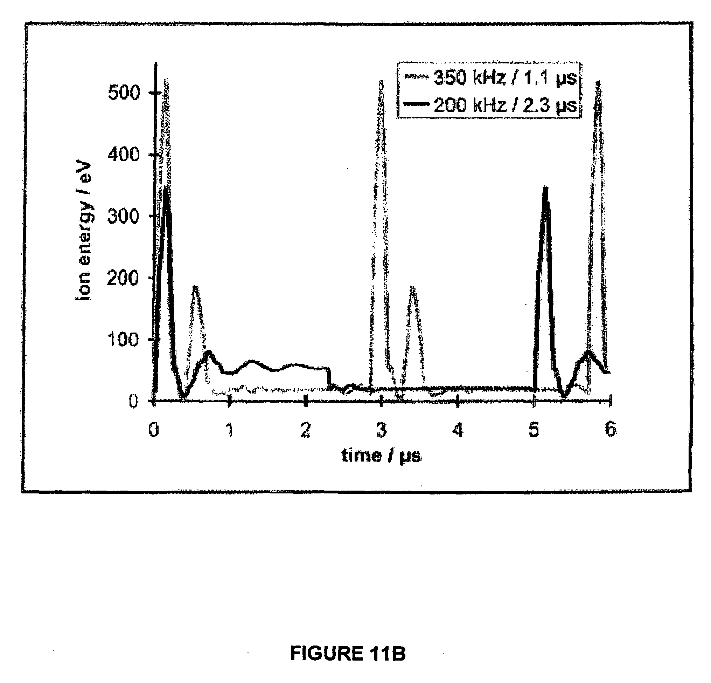

Figure 11A illustrates the output of a power source that uses pulsed-DC waveforms. The first waveform has a frequency of 350 kHz and a reverse-pulse duration of 1.1 µS. The second waveform has a frequency of 200 kHz and a reverse-pulse duration of 2.3 µS. Figure 11B illustrates the ion energy corresponding to these two DC waveforms. Notice that the ion energy spikes to high levels, which can be destructive to crystals growing on the substrate. Power supplies that limit these spikes can be useful for producing higher quality films.

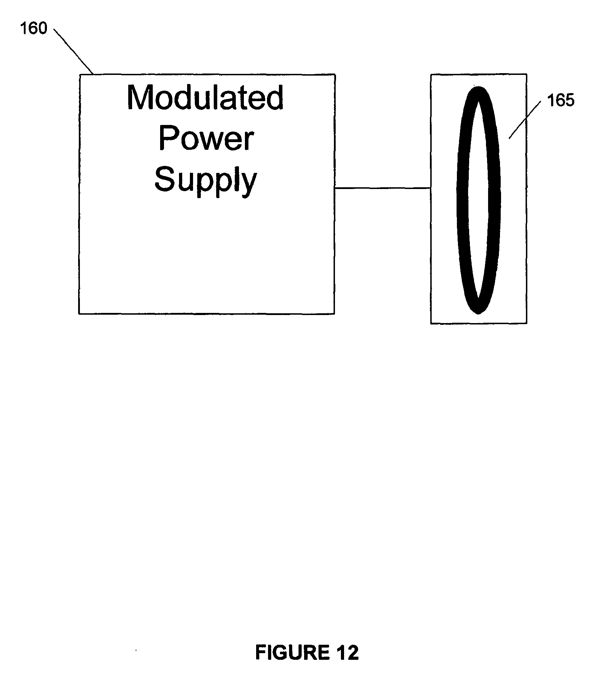

Figure 12 illustrates a power supply 160 and sputtering system 165 constructed in accordance with the principles of the present invention. This system includes a modulated power supply 160 that could include voltage spike suppression or clipping. For example, the power supply 160 could include a pulsed-DC power supply connected ("connected" also means "integrated with") with an RF plasma power supply. It could also include a DC or AC power supply connected with a RF plasma power supply. And in other embodiments, it could include a pulsed-DC power supply, a DC power supply or an AC power supply connected with a programmable modulated-power source. This modulated power source could output a frequency modulated signal, an amplitude modulated signal, a pulse-width modulated signal, a pulse-position modulated signal, etc. ("Sputtering system" can also mean an integrated power supply and sputtering device.)

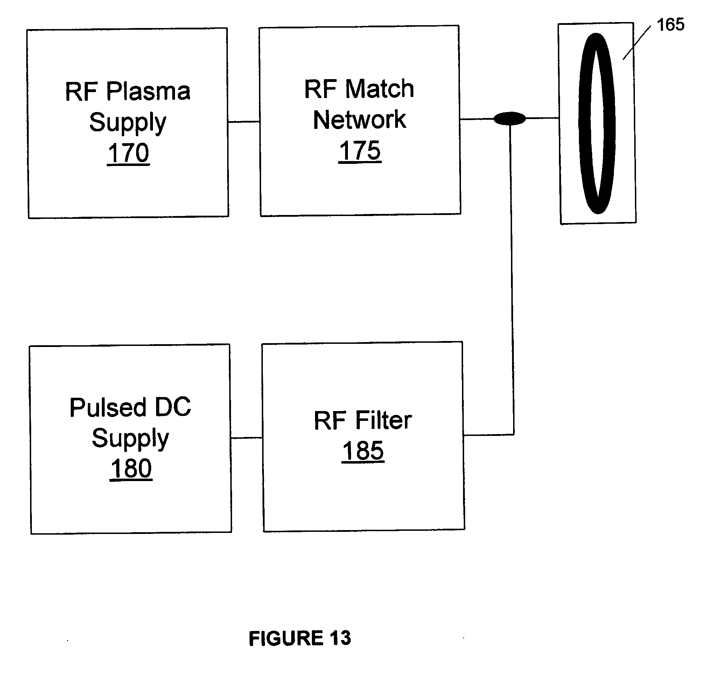

Figure 13 illustrates another embodiment of a power supply and sputtering system constructed in accordance with the principles of the present invention. This implementation includes an RF plasma supply 170 and an RF match network 175 connected to the sputtering system 165. It also includes a pulsed-DC power supply 180 and an RF filter 185 connected to the sputtering system 165. The signals from these two power sources are combined to drive the sputtering system 165. Those of skill in the art understand how to connect and operate these components so the details are not addressed herein.

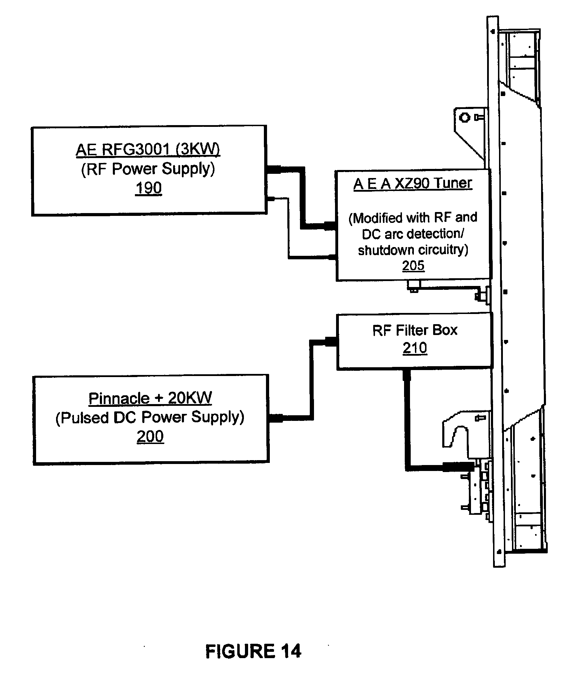

Figure 14 illustrates a particular power supply constructed in accordance with the principles of the present invention. Note that a "power supply" can include multiple power supplies acting together or a single unit capable of producing the desired waveform. And in this implementation, two distinct power supplies ― an RF supply 190 and a pulsed-DC supply 200 ― are coupled together to act as a single power source.

ADVANCED ENERGY's model RFG3001 (3KW) RF power supply provides the RF signal. ADVANCED ENERGY is located in Fort Collins, Colorado. This power supply can be modified for internal or external arc suppression, and the output from this power supply is fed into a tuner 205 such as an ADVANCED ENERGY XZ90 tuner with DC arc detection and shutdown circuitry.

The pulsed-DC power supply in this implementation is provided by PINNACLE and is a 20 KW supply with internal arc suppression. The output from this power supply is fed into a high-current RF filter box 210. This is a standard air or water cooled Tee or Pie filter. And the output from the RF filter box is combined with the output from the tuner and provided to the sputtering system.

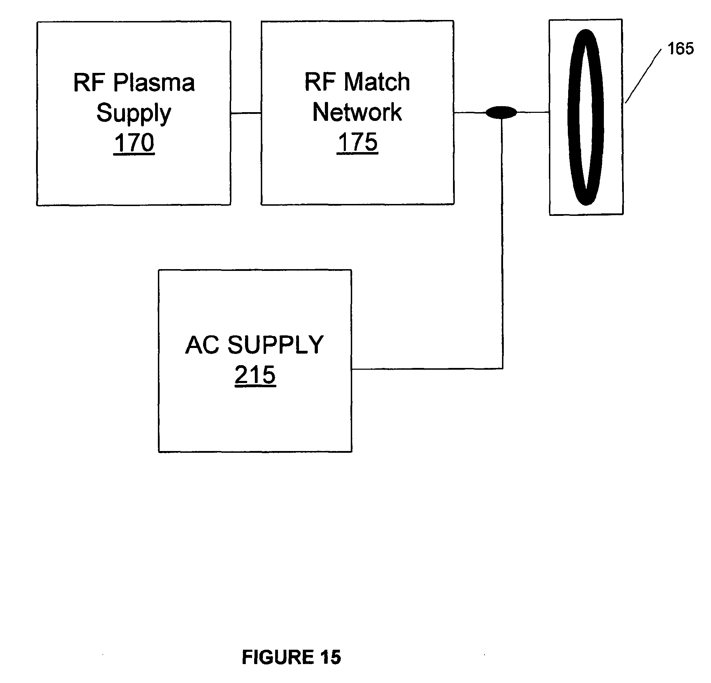

Figure 15 illustrates a power supply and sputtering system constructed in accordance with the principles of the present invention. This system is similar to the system illustrated in system in Figure 13 except that the power supply is an AC power supply 215 rather than a pulsed DC power.

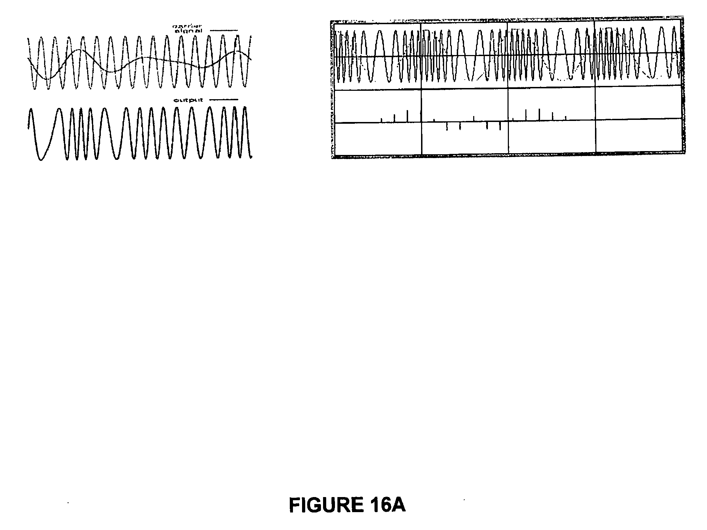

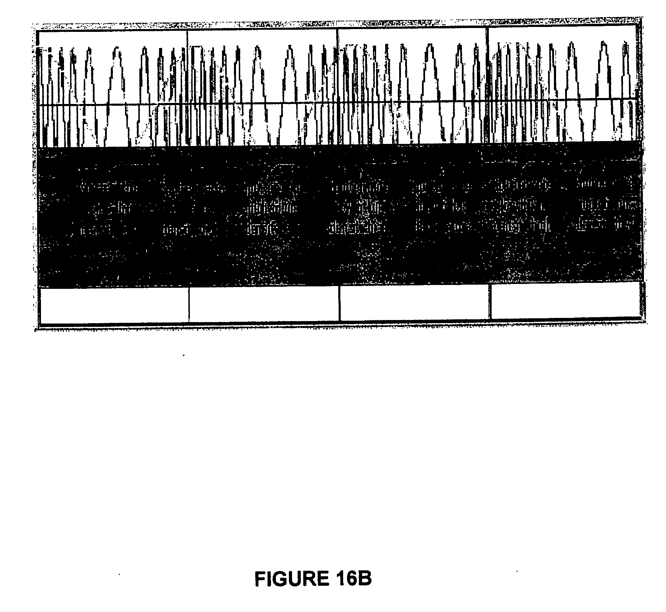

Figures 16-19 illustrate modulated AC power signals that can be used to control ion density and ion energy in a sputtering system ― thereby controlling the film properties and quality. These power signals can be used to achieve the previously-described higher-quality films. Additionally, an RF signal can also be superimposed on any of these modulated power signals to further impact film growth.

Through the variations in amplitude, frequency and pulse width or position, the ratio of ions to sputtered species, sputtering rate and energies of the ions and sputtered species can be controlled. Also important is the ability of some of these modulation methods to control the time for surface mobility on the substrates to occur.

Figure 16A illustrates a frequency-modulated power signal. Frequency modulation (FM) is the encoding of information in either analog or digital form into a carrier wave by variation of its instantaneous frequency in accordance with an input signal. The left-most wave forms in Figure 16A illustrate an arbitrary signal and its impact on frequency.

Figure 16b illustrates the impact on ion density and ion energy of a frequency modulated power signal. Due to a high pulsing frequency, high concentrations of ions are created. During the lower frequency regions, the sputtering rate is high, and during the higher frequency regions, the sputtering rate is low. The ratio of sputtered species to ion varies between the two differing sections. As the sputtering rate is decreased the ions concentration is increased and vice versa. This variation gives unique dynamics for improved film growth.

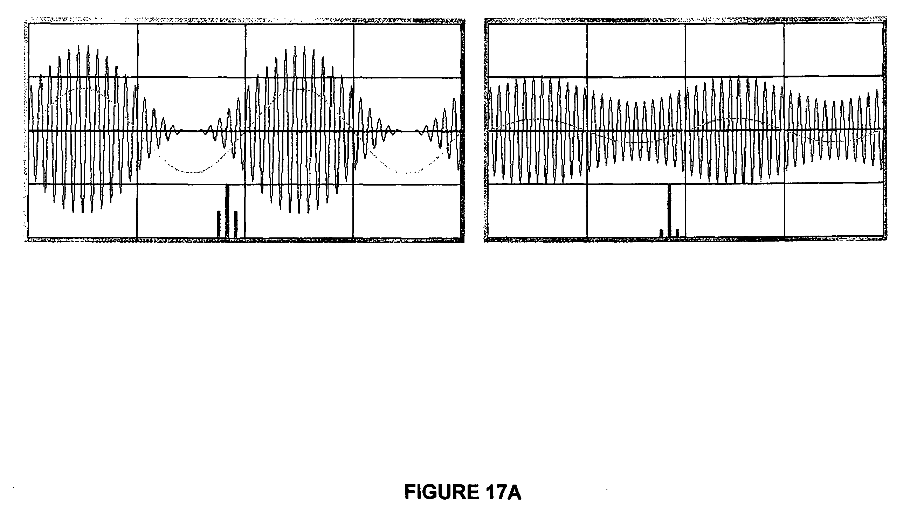

Figure 17a illustrates an amplitude-modulated power signal. Amplitude modulation is a form of signal modulation where the message information is encoded in the amplitude of a series of signal pulses. That is the traditional explanation, but in the case of plasma sources, the voltage, current, and power level can be modulated by what ever percentage desired.

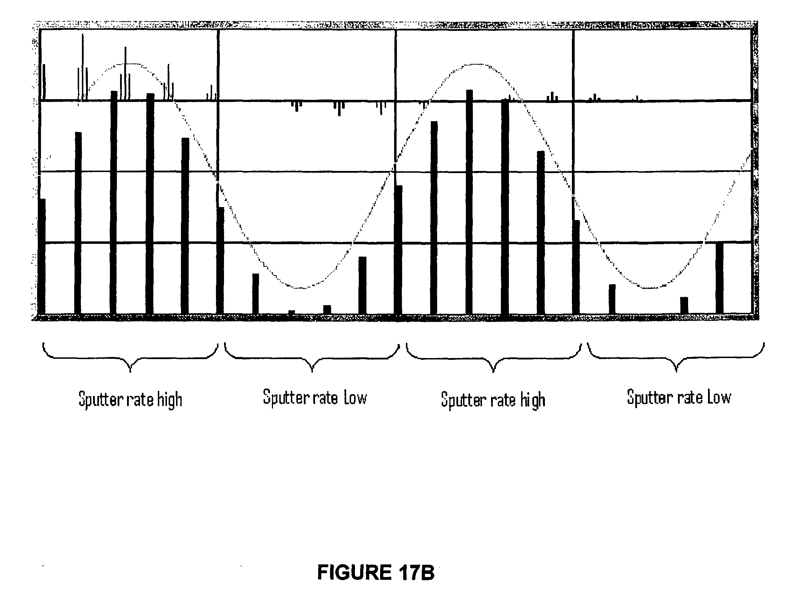

Figure 17b illustrates the impact on ion density and energy caused by an amplitude modulated signal. The amplitude modulation varies the sputtering rate allowing new types of processes and film growth control.

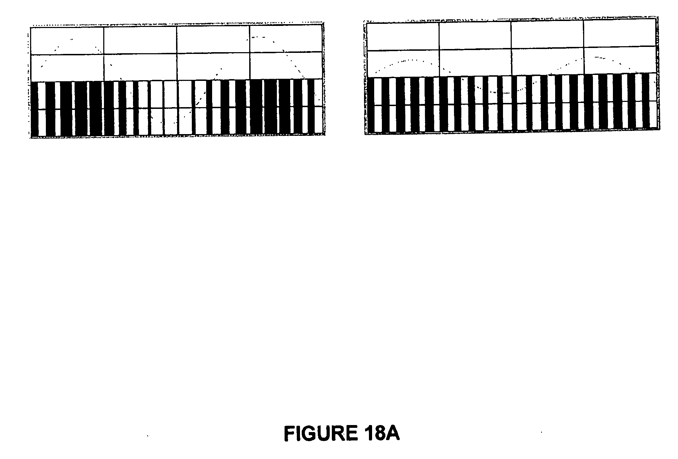

Figure 18a illustrates a pulse-width modulated signal. Pulse-width modulation is a way to represent data over a communications channel. With pulse-width modulation, the value of a sample of data is represented by the length of a pulse.

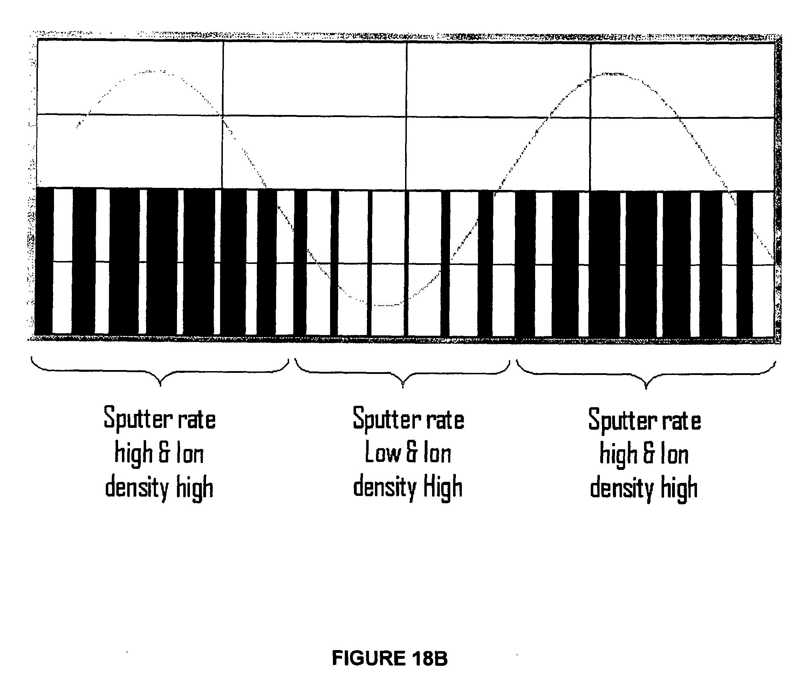

Figure 18b illustrates the impact on ion production and energy of a modulated pulse-width signal. Due to a high pulsing frequency high concentrations of ions are created. During the large pulse width regions, the sputtering rate is high, and during the short pulse width regions, the sputtering rate is low. The ratio of sputtered species to ions varies between the two differing sections.

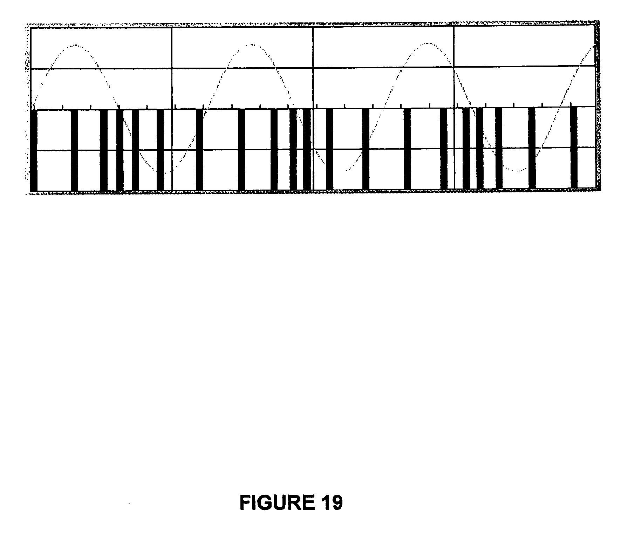

Figure 19 illustrates a pulse-position modulated signal. Pulse-position modulation is a form of signal modulation in which the message information is encoded in the temporal spacing between a sequence of signal pulses. As with the other modulated signals, the encoded information varies ion density and energy.

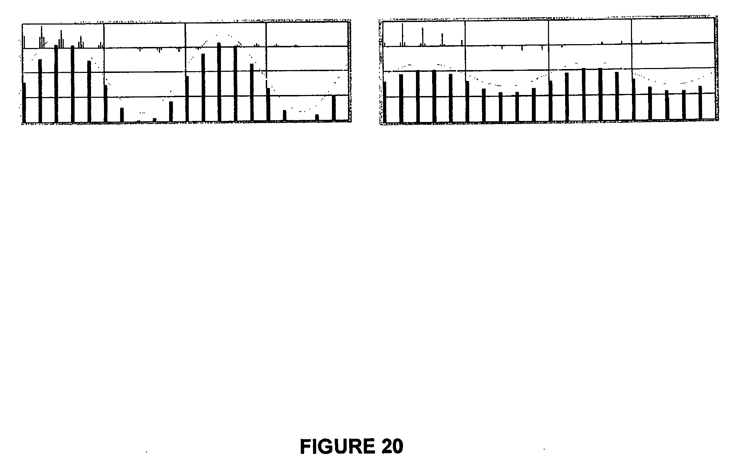

Figures 20-22 illustrate modulated DC power signals that can be used to control ion density and ion energy in a sputtering system ― thereby controlling the film properties and quality. The existing DC and composite DC sputtering processes are limited in some respects in their ability to effectively control film properties. DC and composite DC processes can and do exhibit power limitations as well as the inability to finely control the sputtering process energies. The use of pulsed DC power supplies to sputtering cathodes has benefited many film deposition processes and film properties, especially in conductive transparent films, by better controlling the sputtering energies. This control is achieved due to the fact that these power supplies inherently extinguish and re-ignite the plasma at user defined frequencies and intensities. At the beginning of each power pulse or plasma ignition from either of these systems, there is a broader distribution of electron energies producing ions and therefore, a greater percentage of the sputtered species and ions are generated. In DC and composite DC processes, because there is only an initial plasma ignition, the distribution stabilizes out to a lower average value of electron energy.

With this in mind, it can be said that for pulsed power there are many beginnings and plasma ignitions to increase the average electron / ion energies to a much higher value thus giving this benefit to the process. By controlling the pulse duration and duty cycle you can control the electron / ion energies and the relative number of generated specific sputtered species and ions. Using pulsed power can give the operator effective control over more of the sputtered thin film properties.

Beyond the typical pulsed DC power supplies ― with their user defined frequencies and settings for forward and reversal timing ― is a new area of output power to the sputtering cathodes and in general plasma sources. The new methods and systems provide power that has been modulated in one or more methods. For the most part, the modulation methods that work for AC power supplies also work for DC power supplies. Accordingly, these DC-system illustrations are similar to the previous AC illustrations.

Figure 20 illustrates pulse-amplitude modulation using pulsed DC.

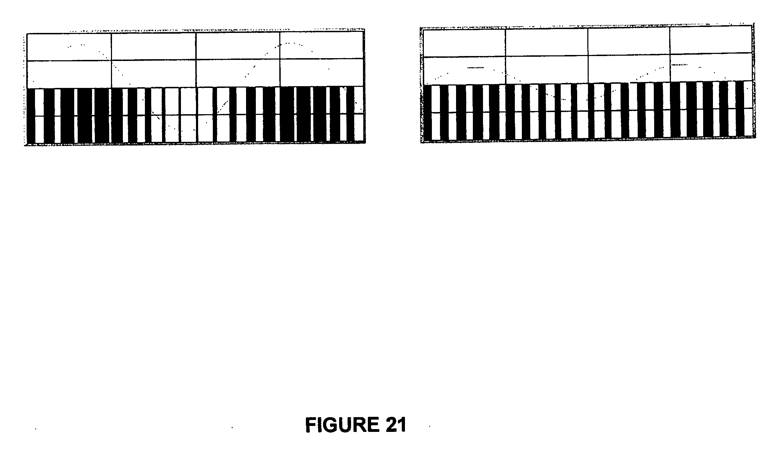

Figure 21 illustrates pulse-width modulation using pulsed DC. With pulse-width modulation, the value of a sample of data is represented by the length of a pulse.

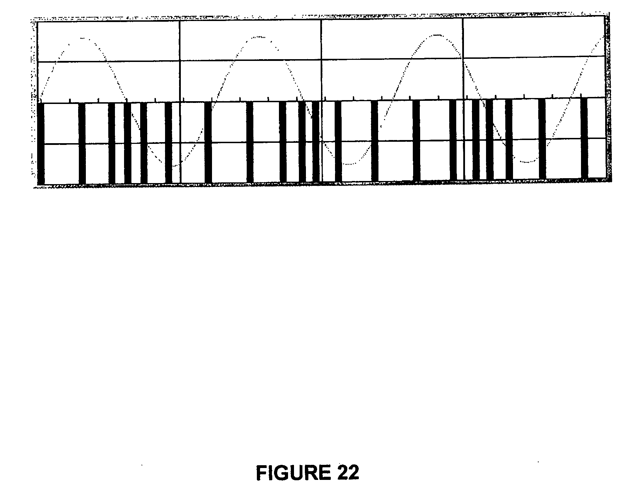

Figure 22 illustrates pulse-position modulation, which is a form of signal modulation in which the message information is encoded in the temporal spacing between a sequence of signal pulses.

Just as with the AC examples, through the variations in amplitude, frequency and pulse width or position, the ratio of ions to sputtered species, sputtering rate and energies of the ions and sputtered species can be controlled. Also important is the ability of some of these modulation methods to control the time for surface mobility on the substrates to occur.

In summary, embodiments of the present invention enable higher yields and higher quality thin films, and different films than possible with standard DC, AC, RF sputtering processes and most likely target materials. This is achieved, in one embodiment, through the ability to control sputtering energies, ion densities, rate and energies to promote improved film growth. Those skilled in the art can readily recognize that numerous variations and substitutions may be made in the invention, its use and its configuration to achieve substantially the same results as achieved by the embodiments described herein. Accordingly, there is no intention to limit the invention to the disclosed exemplary forms. Many variations, modifications and alternative constructions fall within the scope and spirit of the disclosed invention as expressed in the claims.

## Claims

1. A method of controlling ions in a sputtering system that includes at least one cathode, the method comprising:
generating a modulated power signal; and
providing the modulated power signal to the cathode.

2. The method of claim 1, wherein generating a modulated power signal comprises:
generating an amplitude-modulated power signal.

3. The method of claim 1, wherein generating a modulated power signal comprises:
generating an frequency-modulated power signal.

4. The method of claim 1, wherein generating a modulated power signal comprises:
generating an pulse-width modulated power signal.

5. The method of claim 1, wherein generating a modulated power signal comprises:
generating a pulse-amplitude modulated power signal.

6. The method of claim 1, further comprising:
actively varying a characteristic of the modulated power signal while the sputtering system is sputtering to thereby impact film growth.

7. The method of claim 1, wherein the modulated power signal includes a DC signal.

8. The method of claim 1, wherein the modulated power signal includes an AC signal.

9. The method of claim 1, further comprising:
varying the modulation of the modulated power signal to increase ion density.

10. The method of claim 1, further comprising:
varying the modulation of the modulated power signal to decrease ion density.

11. A method for controlling ion density in a sputtering system, the method comprising:
providing a power signal to the sputtering system;
varying at least one characteristic of the power signal to control ion density, wherein the characteristic includes at least one of amplitude, frequency, width, repetition rate, and position.

12. A method for controlling ion density and sputtering rate in a sputtering system, the method comprising:
applying a high-frequency power signal to the cathode to thereby generate a first concentration of ions;
decreasing the frequency of the power signal applied to the cathode to thereby increase the sputtering rate and decrease the first concentration of ions around the cathode;
applying the high-frequency power signal to the cathode to thereby generate a second concentration of ions; and
decreasing the frequency of the power signal applied to the cathode to thereby increase the sputtering rate and decrease the second ion concentration of around the cathode.

13. A method for controlling ion density and sputtering rate in a sputtering system, the method comprising:
applying a first pulse-width power signal to the cathode to thereby generate a first concentration of ions;
decreasing the pulse-width of the first pulse-width power signal applied to the cathode to thereby increase the sputtering rate and decrease the first concentration of ion around the cathode;
applying the first pulse-width power signal to the cathode to thereby generate a second concentration of ions; and
decreasing the pulse-width of the first pulse-width power signal applied to the cathode to thereby increase the sputtering rate and decrease the second concentration of ions around the cathode.

14. A method for controlling ion density and sputtering rate in a sputtering system, the method comprising:
applying a high-amplitude power signal to the cathode to thereby generate a first concentration of ions;
decreasing the amplitude of the power signal applied to the cathode to thereby increase the sputtering rate and decrease the first concentration of ions around the cathode;
applying the high-amplitude power signal to the cathode to thereby generate a second concentration of ions; and
decreasing the amplitude of the power signal applied to the cathode to thereby increase the sputtering rate and decrease the second concentration of ions around the cathode.
